# EUROPEAN PATENT APPLICATION

(11) **EP 4 766 069 A1**
(43) Date of publication of application: **24.06.2026**
(21) Application number: 24853216.0
(22) Date of filing: 09.04.2024
(51) Int. Cl.: H10B 53/20, H10B 53/30, H10B 51/20, H10B 51/30, G11C 11/22

(54) **STORAGE UNIT, MANUFACTURING METHOD THEREFOR, MEMORY, AND ELECTRONIC DEVICE**

(30) Priority: 16.08.2023 CN 202311038185
(71) Applicant: HUAWEI TECHNOLOGIES CO., LTD., Shenzhen 518129 (CN)
(72) Inventor: TAN, Wanliang, Shenzhen, Guangdong 518129 (CN); LI, Yuxing, Shenzhen, Guangdong 518129 (CN); MA, Wenlong, Shenzhen, Guangdong 518129 (CN); XU, Jeffrey Junhao, Shenzhen, Guangdong 518129 (CN)
(74) Representative: Maiwald GmbH
(86) International application number: PCT/CN2024/086702
(87) International publication number: WO 2025/035800

(57) **Abstract**

This application provides a storage unit, a manufacturing method thereof, a memory, and an electronic device. When Helmholtz free energy of a metal element in an introduced first doped layer is lower than Helmholtz free energy of a metal element in a ferroelectric layer, introduction of the first doped layer can help a dielectric layer exhibit ferroelectric performance. When Helmholtz free energy of a metal element in an introduced second doped layer is not lower than the Helmholtz free energy of the metal element in the ferroelectric layer, captured and accumulated electrons may be guided through introduction of the second doped layer, to avoid electron aggregation and accumulation in the dielectric layer, so as to avoid breakdown of the dielectric layer due to electron aggregation and accumulation. Therefore, when a ferroelectric storage unit is obtained, reliability of the dielectric layer and even reliability of the storage unit are improved.

## Description

### CROSS-REFERENCE TO RELATED APPLICATIONS

This application claims priority to Chinese Patent Application No. 202311038185.0, filed with the China National Intellectual Property Administration on August 16, 2023 and entitled "STORAGE UNIT, MANUFACTURING METHOD THEREOF, MEMORY, AND ELECTRONIC DEVICE", which is incorporated herein by reference in its entirety.

### TECHNICAL FIELD

This application relates to the field of storage technologies, and in particular, to a storage unit, a manufacturing method thereof, a memory, and an electronic device.

### BACKGROUND

A ferroelectric memory has advantages such as a low read/write voltage, low power consumption, a small device size, a high read/write speed, good cycle performance, and good radiation resistance and non-volatile property, and is expected to be used to construct a new generation of non-volatile memories. Compared with a conventional ferroelectric material, a hafnium-based ferroelectric material has superior scaling characteristics, and can also overcome technical difficulties and bottlenecks such as incompatibility between the conventional ferroelectric material and a complementary metal oxide semiconductor (Complementary Metal Oxide Semiconductor, CMOS), difficulty in size scaling, and difficulty in implementing high-density integration. Therefore, a hafnium-based ferroelectric device is expected to become a core unit of a new ferroelectric memory in the future.

However, in a storage layer of a hafnium-based ferroelectric memory, to enable a hafnium oxide material to exhibit ferroelectricity, an oxygen vacancy may be generally introduced into hafnium oxide. If there are a large quantity of oxygen vacancies, the oxygen vacancies may capture and accumulate electrons, introduce a built-in electric field, generate nailing effect on an electric domain in a specific polarization direction, and even cause breakdown of the storage layer, resulting in poor reliability of the hafnium-based ferroelectric memory.

### SUMMARY

This application provides a storage unit, a manufacturing method thereof, a memory, and an electronic device, to improve reliability of a hafnium-based ferroelectric memory, and improve performance of the ferroelectric memory.

According to a first aspect, an embodiment of this application provides a storage unit. The storage unit may include a first conductive layer, a function layer, and a dielectric layer arranged between the first conductive layer and the function layer. The dielectric layer may include a ferroelectric layer, a first doped layer, and a second doped layer that are stacked. A manufacturing material of the ferroelectric layer may include, but is not limited to, a hafnium oxide material. A pure hafnium oxide material is difficult to have ferroelectricity. When the first doped layer is introduced, and Helmholtz free energy of a metal element in the first doped layer is lower than Helmholtz free energy of a metal element in the ferroelectric layer, it indicates that the metal in the first doped layer needs low energy during movement. In this way, a defect is more easily generated in the dielectric layer, and a large quantity of oxygen vacancies are generated, so that hafnium oxide can exhibit ferroelectricity through the oxygen vacancies, to form the ferroelectric layer. However, because a defect energy level of the oxygen vacancy is deep, the large quantity of oxygen vacancies may capture and accumulate electrons, introduce a built-in electric field, generate nailing effect on an electric domain in a specific polarization direction, and even may cause breakdown of the dielectric layer. Therefore, when the second doped layer is introduced, and Helmholtz free energy of a metal element in the second doped layer is not lower than the Helmholtz free energy of the metal element in the ferroelectric layer, it indicates that the metal in the second doped layer needs high energy during movement. A small quantity of defects are generated in the dielectric layer and energy levels of the defects are shallow. These defects with shallow energy levels can guide the captured and accumulated electrons, to avoid electron aggregation and accumulation in the dielectric layer, so as to avoid breakdown of the dielectric layer due to electron aggregation and accumulation. Therefore, through introduction of the first doped layer and the second doped layer that have different functions, the ferroelectric layer can be obtained, and reliability of the dielectric layer and even reliability of the storage unit can be further improved.

It should be understood that, in addition to the hafnium oxide material, the manufacturing material of the ferroelectric layer may include another material having a characteristic similar to that of the hafnium oxide material. This is not limited herein. The characteristic of the hafnium oxide material means that the pure hafnium oxide material is difficult to exhibit the ferroelectricity. When the oxygen vacancy is introduced or the first doped layer is introduced, hafnium oxide can exhibit the ferroelectricity.

For the introduced first doped layer and second doped layer: A plurality of first doped layers may be arranged, and a ferroelectric layer is arranged between two adjacent first doped layers. A plurality of second doped layers may also be arranged, and a ferroelectric layer is also arranged between two adjacent second doped layers. In addition, a ferroelectric layer is arranged between the first doped layer and the second doped layer. In this way, the first doped layer and the second doped layer may be separated through the ferroelectric layer, and the first doped layers may be separated through the ferroelectric layer and the second doped layers may be separated through the ferroelectric layer, to implement uniform ferroelectric distribution in the dielectric layer. When there are also a plurality of ferroelectric layers, the ferroelectric layers, the first doped layers, and the second doped layers may be alternately stacked or non-alternately stacked, provided that a ferroelectric layer is arranged between different first doped layers, a ferroelectric layer is arranged between different second doped layers, and a ferroelectric layer is arranged between the first doped layer and the second doped layer. A specific stacking manner of the ferroelectric layer, the first doped layer, and the second doped layer may be designed based on an actual requirement. This is not limited herein.

For example, in addition to the requirement of the Helmholtz free energy, the metal element in the first doped layer may meet the following requirement: A difference between an atomic radius of the metal element in the first doped layer and an atomic radius of the metal element in the ferroelectric layer is not less than a threshold, that is, the difference between the atomic radius of the metal element in the first doped layer and the atomic radius of the metal element in the ferroelectric layer is large. In this way, when the metal in the first doped layer is introduced, a caused lattice distortion of a material in the ferroelectric layer is large, and crystallization of the material in the ferroelectric layer is greatly affected, thereby facilitating formation of the ferroelectric layer. Alternatively, a valence state of the metal element in the first doped layer is lower than a valence state of the metal element in the ferroelectric layer. In this way, stability of bonding between the metal in the first doped layer and oxygen is low, and a large quantity of oxygen vacancies are easily introduced. This also has large impact on crystallization of the material in the ferroelectric layer, thereby facilitating formation of the ferroelectric layer. Alternatively, a difference between an atomic radius of the metal element in the first doped layer and an atomic radius of the metal element in the ferroelectric layer is not less than a threshold, and a valence state of the metal element in the first doped layer is lower than a valence state of the metal element in the ferroelectric layer. In this way, formation of the ferroelectric layer can be facilitated from two perspectives of causing a lattice distortion of a material in the ferroelectric layer and introducing an oxygen vacancy. In this case, the metal element in the first doped layer may include, but is not limited to, at least one of lanthanum, cerium, molybdenum, zirconium, silicon, gadolinium, yttrium, and the like. It should be understood that a metal may have a plurality of valence states, but provided that one of the valence states is lower than the valence state of the metal element in the ferroelectric layer, it may be considered that the metal meets the requirement that the valence state is lower than the valence state of the metal element in the ferroelectric layer.

In addition, an example in which the manufacturing material of the ferroelectric layer includes the hafnium oxide material is used. The hafnium oxide material has a plurality of phase structures, where a T phase, an O phase, and an M phase are the most common. A ferroelectric phase is a type of the O phase. In a heat treatment process, hafnium oxide may form the T phase as a temperature rises, and then is converted into the O phase or the M phase in a cooling process. When the first doped layer includes one metal element, the metal element may stabilize hafnium oxide in the O phase, so that hafnium oxide exhibits the ferroelectricity, to form the ferroelectric layer. Alternatively, when the first doped layer includes a plurality of metal elements, some metal elements (which are denoted as a type-A metal element) in these metal elements are used to stabilize hafnium oxide in the O phase, so that hafnium oxide exhibits the ferroelectricity, to form the ferroelectric layer. Therefore, a function of the type-A metal element includes facilitating formation of the ferroelectric layer Some other metal elements (which are denoted as a type-B metal element) in these metal elements are used to cause hafnium oxide to form the T phase, to reduce a heat treatment temperature and reduce a thermal budget needed for crystallization. Therefore, a function of the type-B metal element includes reducing the heat treatment temperature needed in a ferroelectric layer forming process, so that when the ferroelectric layer is obtained and reliability of the dielectric layer is improved, the thermal budget for forming the ferroelectric layer can be further reduced. The type-A metal element may include, but is not limited to, at least one of lanthanum, cerium, molybdenum, and the like, and the type-B metal element may include, but is not limited to, at least one of zirconium, silicon, gadolinium, yttrium, and the like.

Similarly, in addition to the requirement of the Helmholtz free energy, the metal element in the second doped layer may meet the following requirement: A difference between an atomic radius of the metal element in the second doped layer and the atomic radius of the metal element in the ferroelectric layer is less than the threshold, that is, the atomic radius of the metal element in the second doped layer is close to the atomic radius of the metal element in the ferroelectric layer. In this way, when the metal in the second doped layer is introduced, the caused lattice distortion of the material in the ferroelectric layer is small, impact on crystallization of the material in the ferroelectric layer is small, and a generated defect energy level is shallow, so that accumulated electrons can be guided, thereby avoiding electron aggregation. Alternatively, a valence state of the metal element in the second doped layer is not lower than the valence state of the metal element in the ferroelectric layer. In this way, bonding between the metal in the second doped layer and oxygen is relatively stable, it is difficult to introduce an oxygen vacancy or a small quantity of oxygen vacancies are introduced, and a generated defect energy level is shallow, so that accumulated electrons can be guided, thereby avoiding electron aggregation. Alternatively, a difference between an atomic radius of the metal element in the second doped layer and the atomic radius of the metal element in the ferroelectric layer is less than the threshold, and a valence state of the metal element in the second doped layer is not lower than the valence state of the metal element in the ferroelectric layer. In this case, the metal element in the second doped layer may include, but is not limited to, at least one of titanium and niobium. It should be understood that a metal may have a plurality of valence states, but provided that one of the valence states is not lower than the valence state of the metal element in the ferroelectric layer, it may be considered that the metal meets the requirement that the valence state is not lower than the valence state of the metal element in the ferroelectric layer.

The threshold may be set based on factors such as requirements for a storage window and reliability of the storage unit. For example, the threshold may be set to 10 pm. This is not limited herein. It should be understood that, a ferroelectric polarization state is strong and remains unchanged within the storage window of the storage unit, and the polarization state is weak or flips outside the storage window. Therefore, the storage window of the storage unit has a high storage capacity, so that information can be stably recorded, and data storage can be implemented.

The storage unit may include a transistor and a storage capacitor. When the dielectric layer is used in the storage capacitor, the function layer may be used as a second conductive layer in the storage capacitor, and the first conductive layer and the second conductive layer are separately arranged on two sides of the dielectric layer, to form the storage capacitor. A storage window of the dielectric layer in the storage capacitor affects storage performance of the storage capacitor, and further affects performance of the storage unit. Through introduction of the first doped layer, the ferroelectric layer may be obtained, to obtain a sufficient storage window, so as to implement data storage. In addition, through introduction of the second doped layer, reliability of the dielectric layer can be improved, so that the reliability of the dielectric layer is improved without losing the storage window.

When the dielectric layer is used in the transistor, the function layer may be used as a channel of the transistor, and correspondingly, the first conductive layer may be used as a gate of the transistor. The dielectric layer is used as a gate insulation layer of the transistor to isolate the channel from the gate, to avoid a short circuit between the channel and the gate. Therefore, when the dielectric layer has good reliability, reliability and performance of the transistor are also improved.

In addition, the storage capacitor is used as an example. When the storage capacitor is arranged on a substrate, the first conductive layer, the dielectric layer, and the function layer may be stacked in a direction perpendicular to a surface of the substrate, and the dielectric layer is arranged between the first conductive layer and the function layer. In this case, the storage capacitor may be considered as a storage capacitor having a two-dimensional structure. Alternatively, the function layer and an insulation layer may be alternately stacked in a direction perpendicular to a surface of the substrate to form a stacked structure, and then a through hole is excavated in the stacked structure. The through hole runs through the stacked structure in the stacking direction, and then the through hole is sequentially filled with the dielectric layer and the first conductive layer. The dielectric layer is arranged between the stacked structure and the first conductive layer. In this case, a stacking direction of the ferroelectric layer, the first doped layer, and the second doped layer is perpendicular to an extension direction of the through hole. In this case, the formed storage capacitor may be considered as a storage capacitor having a three-dimensional structure. The transistor is similar to the storage capacitor, and a transistor having a two-dimensional structure or a transistor having a three-dimensional structure may also be manufactured. Details are not described herein.

For example, a manufacturing material of the first conductive layer may include any material having a conductive function, for example, but not limited to, a metal, a metal oxide, and a conductive organic material. Specifically, the material may be selected based on an actual requirement. This is not limited herein. When the function layer is used as the second conductive layer, a manufacturing material of the function layer may be the same as or different from the manufacturing material of the first conductive layer, and may be specifically selected based on an actual requirement. This is not limited herein. When being used as the channel of the transistor, the function layer may be made of a semiconductor material, and selection may be specifically performed based on an actual requirement. This is not limited herein.

Certainly, the first conductive layer and the function layer used as the second conductive layer each may be referred to as a conductive film layer. For example, a film layer having an auxiliary function, for example, but not limited to, an adhesion layer or an interface passivation layer, may be arranged between the conductive film layer and the dielectric layer. When the adhesion layer is arranged, adhesion between the dielectric layer and the conductive film layer may be increased through the adhesion layer, to avoid detachment between the conductive film layer and the dielectric layer during use of the storage unit, so as to further improve the reliability of the storage unit. A manufacturing material of the adhesion layer may be selected based on a manufacturing material of the conductive film layer. Any material that can serve an adhesion function may be used to manufacture the adhesion layer. When the interface passivation layer is arranged, element diffusion between the dielectric layer and the conductive film layer can be suppressed through the interface passivation layer, to avoid function degradation of the conductive film layer and the dielectric layer, so as to improve ferroelectricity of the dielectric layer and improve the reliability of the storage unit. A manufacturing material of the interface passivation layer may also be selected based on the manufacturing material of the conductive film layer. Any material that can serve an interface passivation function may be used to manufacture the interface passivation layer.

According to a second aspect, an embodiment of this application further provides a storage unit manufacturing method. A storage unit manufactured by using the manufacturing method may be the storage unit described in any one of the first aspect and the possible implementations of the first aspect. The manufacturing method may include: forming a function layer; stacking and forming a ferroelectric layer, a first doped layer, and a second doped layer on the function layer, so that the ferroelectric layer, the first doped layer, and the second doped layer form a dielectric layer, where Helmholtz free energy of a metal element in the first doped layer is lower than Helmholtz free energy of a metal element in the ferroelectric layer, and Helmholtz free energy of a metal element in the second doped layer is not lower than the Helmholtz free energy of the metal element in the ferroelectric layer; and forming a first conductive layer on the dielectric layer. In this way, introduction of the first doped layer can help the dielectric layer exhibit ferroelectric performance, and captured and accumulated electrons can be guided through introduction of the second doped layer, to avoid electron aggregation and accumulation in the dielectric layer, so as to breakdown of the dielectric layer due to electron aggregation and accumulation. Therefore, when a ferroelectric storage unit is obtained, reliability of the dielectric layer and even reliability of the storage unit are improved.

For example, stacking and forming the ferroelectric layer, the first doped layer, and the second doped layer on the function layer may include: stacking and forming an initial film layer, the first doped layer, and the second doped layer on the function layer, and then performing heat treatment on the initial film layer, the first doped layer, and the second doped layer, so that the initial film layer is converted into the ferroelectric layer, to form the dielectric layer on the function layer. In other words, when the dielectric layer is formed, the initial film layer, the first doped layer, and the second doped layer that are stacked may be formed by using a physical vapor deposition method or a chemical vapor deposition method; and heat treatment is performed on the initial film layer, the first doped layer, and the second doped layer, so that the initial film layer is converted into the ferroelectric layer. An atomic layer deposition method is used as an example. Because a thickness of a film layer obtained through each time of deposition by using the atomic layer deposition method is limited, a plurality of continuous times of deposition may be performed to obtain a film layer of a target thickness. For example, when the initial film layer is deposited by using the atomic layer deposition method, an example in which the initial film layer is manufactured by using hafnium oxide is used. A hafnium oxide layer may be continuously deposited for a plurality of times, so that a thickness of the hafnium oxide layer that is continuously deposited for the plurality of times reaches a target thickness, to obtain the initial film layer. In addition, the first doped layer and the second doped layer are used to facilitate formation of the ferroelectric layer and improve reliability of the ferroelectric layer. Therefore, a thickness of the first doped layer and a thickness of the second doped layer do not need to be set to be thick, and the first doped layer and the second doped layer are deposited once by using the atomic layer deposition method. The dielectric layer of the target thickness may be obtained through stacking of a plurality of ferroelectric layers, a plurality of first doped layers, and a plurality of second doped layer.

An example in which the initial film layer is manufactured by using hafnium oxide is used. A heat treatment process may include: First, heating the initial film layer, the first doped layer, and the second doped layer to a first preset temperature, so that hafnium oxide forms a T phase in a heating process, and then cooling the initial film layer, the first doped layer, and the second doped layer to a second preset temperature, so that hafnium oxide is converted from the T phase to an O phase and is stabilized in the O phase in a cooling process. Therefore, hafnium oxide exhibits ferroelectricity, and the initial film layer obtained through heat treatment may be converted into the ferroelectric layer. It should be understood that the first preset temperature is higher than the second preset temperature, and the first preset temperature and the second preset temperature may be selected based on factors such as formation temperatures of the T phase and the O phase. This is not limited herein.

Certainly, the heat treatment process is not limited to being performed before the first conductive layer is formed, and may also be performed after the first conductive layer is formed. In this case, the storage unit manufacturing method may specifically include: forming the function layer; forming an initial dielectric layer in contact with the function layer, where the initial dielectric layer includes: the initial film layer, the first doped layer, and the second doped layer that are stacked; forming the first conductive layer on the initial dielectric layer; and performing heat treatment, so that the initial film layer is converted into the ferroelectric layer, to form the dielectric layer. For a heat treatment process, refer to the heat treatment process in the foregoing content. Details are not described herein again.

For example, when the dielectric layer is used in a storage capacitor, and the storage capacitor is of a three-dimensional structure, forming the function layer may include: forming the function layer and an insulation layer that are alternately arranged. A manufacturing material of the insulation layer may be any material that can serve an insulation function. This is not limited herein.

Because a principle of resolving a problem by using the storage unit manufactured by using the manufacturing method is similar to the principle of resolving a problem by using the storage unit, for a technical effect of the manufacturing method, refer to the embodiment and technical effects of the foregoing storage unit. Details are not described again.

According to a third aspect, an embodiment of this application further provides a memory. The memory may include a storage array and a controller coupled to the storage array. The storage array includes a plurality of storage units described in any one of the first aspect and the possible implementations of the first aspect. The plurality of storage units are deployed in an array manner. The storage array is configured to store data. The controller is configured to write data into the storage array or read data from the storage array. In this way, based on improved reliability of the storage unit, reliability of the memory is also improved, thereby improving performance of the memory. Because a principle of resolving a problem by using the memory is similar to the principle of resolving a problem by using the foregoing storage unit, for an embodiment and a technical effect of the memory, refer to the embodiment and the technical effect of the foregoing storage unit. Details are not described again.

For example, when the storage unit includes a transistor and at least one storage capacitor, the memory may further include a word line, a bit line, and at least one control line. When the storage units in the storage array are deployed in an array manner, storage units located in a same row may be connected to a same word line, and storage units located in different rows are connected to different word lines, so that different word lines can control on and off of transistors in the storage units located in different rows. Storage units located in a same column may be connected to a same bit line, and storage units located in different columns are connected to different bit lines, so that different bit lines may provide voltages for storage units in different rows. Each control line is connected to a second terminal of each storage capacitor of each storage unit, that is, each storage unit is connected to each control line. A set quantity of control lines is the same as a set quantity of storage capacitors in the storage unit, and the control lines one to one correspond to the storage capacitors. Therefore, each storage unit can be accurately controlled by using the word line and the bit line, and accurate data writing and reading are implemented under an effect of a voltage provided by each control line.

According to a fourth aspect, an embodiment of this application further provides an electronic device. The electronic device may include a circuit board and the memory described in any one of the second aspect and the possible implementations of the second aspect, where the memory is arranged on the circuit board. In this way, based on improved reliability of the memory, reliability of the electronic device is also improved, thereby improving performance of the electronic device. Because a principle of resolving a problem by using the electronic device is similar to the principle of resolving a problem by using the foregoing memory, for an embodiment and a technical effect of the electronic device, refer to the embodiment and the technical effect of the foregoing memory. Details are not described again.

### BRIEF DESCRIPTION OF DRAWINGS

FIG. 1 is a diagram of a structure of an electronic device according to an embodiment of this application;
FIG. 2 is a diagram of a structure of a memory according to an embodiment of this application;
FIG. 3 is a diagram of a structure of a storage capacitor in a storage unit according to an embodiment of this application;
FIG. 4 is a diagram of a structure of a storage capacitor in another storage unit according to an embodiment of this application;
FIG. 5 is a diagram of a principle according to an embodiment of this application;
FIG. 6 is a diagram of a structure of a transistor in a storage unit according to an embodiment of this application;
FIG. 7 is a diagram of a structure of a storage capacitor in still another storage unit according to an embodiment of this application;
FIG. 8 is a flowchart of manufacturing a storage unit according to an embodiment of this application;
FIG. 9 is another flowchart of manufacturing a storage unit according to an embodiment of this application;
FIG. 10 is still another flowchart of manufacturing a storage unit according to an embodiment of this application; and
FIG. 11 is yet another flowchart of manufacturing a storage unit according to an embodiment of this application.

### DESCRIPTION OF EMBODIMENTS

To make the objectives, technical solutions, and advantages of this application clearer, the following further describes this application in detail with reference to the accompanying drawings.

It should be noted that same reference numerals in the accompanying drawings of this application denote same or similar structures. Therefore, repeated descriptions thereof are omitted. Expressions of locations and directions in this application are described by using the accompanying drawings as an example. However, changes may also be made as required, and all the changes fall within the protection scope of this application. The accompanying drawings in this application are merely used to illustrate relative location relationships and do not represent an actual scale.

For ease of understanding the technical solutions provided in embodiments of this application, the following first describes an application scenario of the technical solutions.

A storage unit may be widely used in a device having a storage function, for example, may be used in a storage device having only a storage function, for example, a memory, or may be used in an electronic device having a storage function and another function (for example, a read/write function). The electronic device may be a portable electronic device that includes functions such as a personal digital assistant and/or a music player, such as a mobile phone, a tablet computer, a wearable device (for example, a smartwatch) having a wireless communication function, or a vehicle-mounted device. An example of an embodiment of the portable electronic device includes, but is not limited to, a portable electronic device using iOS^{®}, Android^{®}, Microsoft^{®}, or another operating system. The portable electronic device may alternatively be, for example, a laptop computer (Laptop) with a touch-sensitive surface (for example, a touch panel). It should be further understood that in some other embodiments of this application, the electronic device may alternatively be a desktop computer with a touch-sensitive surface (for example, a touch panel).

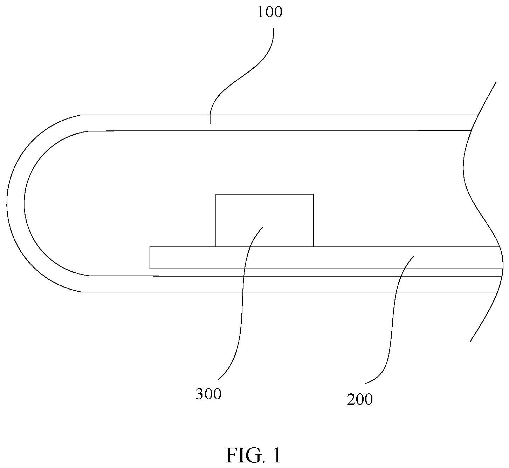

FIG. 1 is a diagram of a structure when a memory is used in an electronic device. Refer to FIG. 1. The electronic device includes a housing 300 and a circuit board 200 arranged in the housing 300. A memory 100 is arranged on the circuit board 200. The memory 100 may be a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. It should be noted that the memory described in this application aims to include, but is not limited to, these memories and any memory of another proper type.

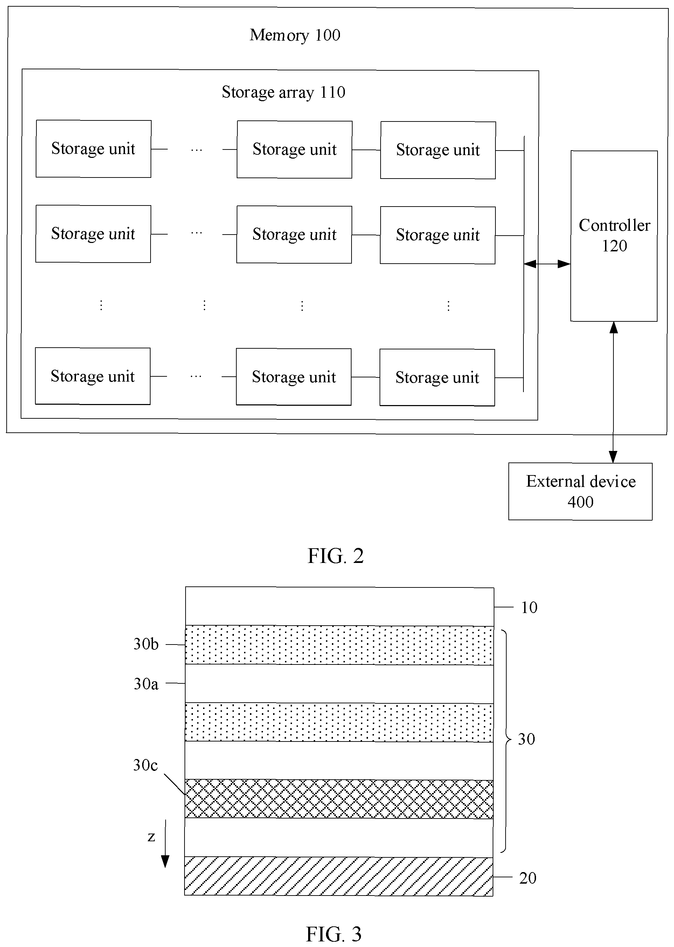

FIG. 2 is an example diagram of an internal structure of a memory 100 to which an embodiment of this application is applicable. It should be understood that the memory 100 shown in the figure is merely an example. The memory 100 may have more or fewer components than those shown in the figure, two or more components may be combined, or different component configurations may be used. Various components shown in the figure may be implemented by using hardware software, or a combination of the hardware and the software including one or more signal processing and/or application-specific integrated circuits,.

As shown in FIG. 2, the memory 100 may include a storage array 110 and a controller 120. The storage array 110 is configured to store data, and is a matrix array formed by arranging a plurality of storage units in a row-column manner. Each storage unit can be configured to store one or more bits of binary data, for example, "0" and/or "1". The plurality of storage units may be located on different tracks of a same disk, or may be located on different disks. This is not specifically limited. The controller 120 is configured to perform a read operation or a write operation on data in the storage array 110, and is a component having a control capability. The controller 120 may be connected to the storage array 110, and a connection manner may be, for example, a bus connection. The controller 120 may include a plurality of functional components, for example, including but not limited to a drive circuit, a decoding circuit, and an amplifier circuit. These functional components may be separately arranged as independent components, may be implemented in one component, or may be arranged in at least two components in any combination manner. This is not specifically limited.

Still refer to FIG. 2. The controller 120 may be further connected to an external device 400. The external device 400 may be, for example, a read/write device or a processor. When reading/writing data, the external device 400 may send a read/write request to the controller 120, where the read/write request carries row address information and column address information of a to-be-read/written target storage unit. The controller 120 decodes the row address information in the read/write request to determine a row in which the target storage unit is located, enables, by using a decoding selection signal, all storage units corresponding to the row in which the target storage unit is located, then decodes the column address information in the read/write request to obtain a column in which the target storage unit is located, reads data stored in the target storage unit in the column, and sends the data to the external device 400, or writes to-be-written data sent by the external device 400 to the target storage unit in the column.

Although not shown in FIG. 2, the memory 100 may further include other components, for example, a main memory data register (memory data register, MDR) and a main memory address register (memory address register, MAR). Details are not described herein.

As a new type of memory having both high-speed reading/writing and non-volatile performance, a ferroelectric memory is gradually used. A core structure of the ferroelectric memory is a metal-ferroelectric layer-metal device structure. A ferroelectric layer is used as a storage medium, "0" and "1" are written and read by using two ferroelectric polarization states, and the two ferroelectric polarization states may still remain unchanged even after an electric field is withdrawn. The ferroelectric layer may be made of a hafnium oxide material. The hafnium oxide material has a plurality of phase structures, where a T phase, an O phase, and an M phase are the most common. A ferroelectric phase is a type of the O phase. A size of a storage window of the ferroelectric memory is determined by a proportion of the O phase and a polar axis direction. The proportion of the O phase is positively correlated with the storage window, and a degree of proximity between the polar axis direction and a C-axis direction is positively correlated with the storage window. Therefore, the proportion of the O phase and the polar axis direction may be adjusted to adjust the storage window. A pure hafnium oxide material is extremely difficult to be stabilized in the O phase. Therefore, the pure hafnium oxide material is difficult to reflect a ferroelectric phase. Element doping may affect crystallization and crystal phase formation of hafnium oxide. Therefore, hafnium oxide may exhibit the ferroelectric phase through element doping, so that a hafnium oxide-based ferroelectric material is obtained.

Reliability of the hafnium oxide-based ferroelectric material also needs to be considered when the hafnium oxide-based ferroelectric material is applied to a memory as a dielectric layer. When the hafnium oxide-based ferroelectric material is applied to a storage capacitor as a storage layer (namely, the dielectric layer), if there are a large quantity of oxygen vacancies, the oxygen vacancies may capture and accumulate electrons, introduce a built-in electric field, generate nailing effect on an electric domain in a specific polarization direction, and even cause breakdown of a storage medium, resulting in poor reliability of a hafnium oxide-based ferroelectric memory. When the hafnium oxide-based ferroelectric material is used as a gate insulation layer in a transistor, if there are a large quantity of oxygen vacancies, the gate insulation layer may still be broken down, resulting in poor reliability of the hafnium oxide-based ferroelectric memory.

Therefore, embodiments of this application provide a storage unit, a manufacturing method thereof, a memory, and an electronic device, to improve reliability of the hafnium oxide-based ferroelectric memory, and improve performance of the ferroelectric memory.

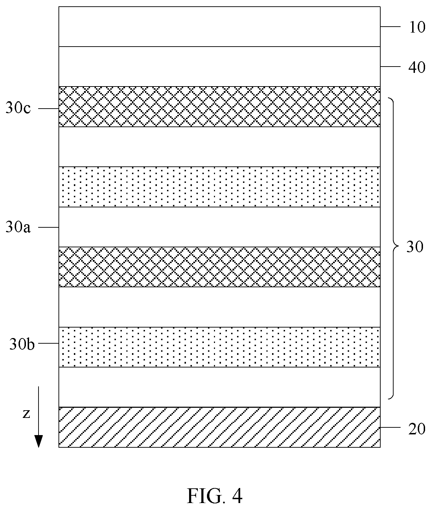

In a first embodiment, FIG. 3 and FIG. 4 are examples of diagrams of a structure of a storage unit according to embodiments of this application. Refer to FIG. 3 and FIG. 4. The storage unit may include a first conductive layer 10, a function layer 20, and a dielectric layer 30 arranged between the first conductive layer 10 and the function layer 20. The dielectric layer 30 may include a ferroelectric layer 30a, a first doped layer 30b, and a second doped layer 30c that are stacked. As shown in FIG. 3, when a plurality of first doped layers 30b are arranged, a ferroelectric layer 30a is arranged between two adjacent first doped layers 30b. As shown in FIG. 4, when a plurality of second doped layers 30c are arranged, a ferroelectric layer 30a is also arranged between two adjacent second doped layers 30c, and a ferroelectric layer 30a is arranged between the first doped layer 30b and the second doped layer 30c. In this way, the first doped layer 30b and the second doped layer 30c may be separated through the ferroelectric layer 30a, and the first doped layers 30b may be separated through the ferroelectric layer 30a and the second doped layers 30c may be separated through the ferroelectric layer 30a, to implement uniform ferroelectric distribution in the dielectric layer 30. When there are also a plurality of ferroelectric layers 30a, the ferroelectric layers 30a, the first doped layers 30b, and the second doped layers 30c may be alternately stacked (as shown in FIG. 4) or non-alternately stacked (as shown in FIG. 3), provided that a ferroelectric layer 30a is arranged between different first doped layers 30b, a ferroelectric layer 30a is arranged between different second doped layers 30c, and a ferroelectric layer 30a is arranged between the first doped layer 30b and the second doped layer 30c. A specific stacking manner of the ferroelectric layer 30a, the first doped layer 30b, and the second doped layer 30c may be designed according to an actual requirement. This is not limited herein.

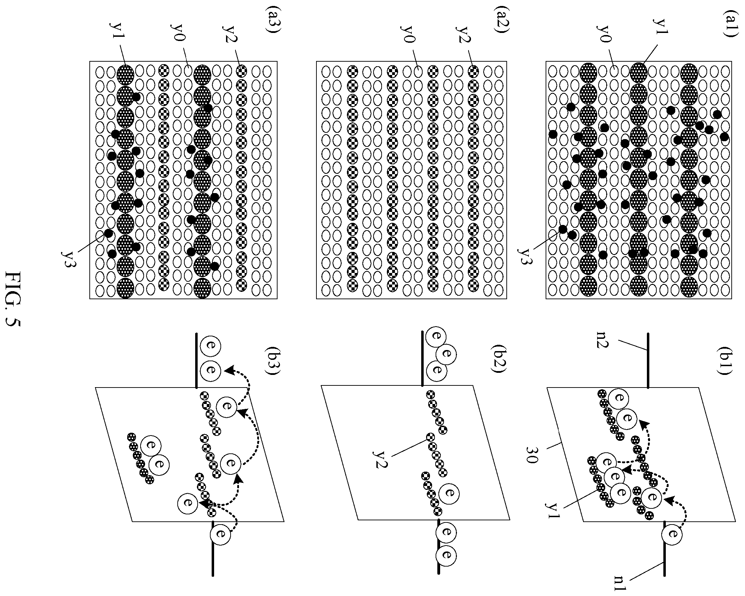

With reference to a principle diagram shown in FIG. 5 and the following Table 1, a manufacturing material of the ferroelectric layer 30a may include, but is not limited to, a hafnium oxide material, and a pure hafnium oxide material is difficult to have ferroelectricity. As shown in al in FIG. 5, when the dielectric layer 30 includes only a hafnium oxide layer and the first doped layer 30b, if Helmholtz free energy of a metal element (as shown by yl in a1 in FIG. 5) in the first doped layer 30b is lower than Helmholtz free energy of a metal hafnium (as shown by y0 in a1 in FIG. 5), it indicates that the metal element y1 in the first doped layer 30b needs low energy during movement. In this way, a defect is more easily generated in the dielectric layer 30, and a large quantity of oxygen vacancies (as shown by y3 in a1 in FIG. 5) are generated, so that the hafnium oxide layer can exhibit ferroelectricity through the oxygen vacancy y3, to form the ferroelectric layer 30a. However, because a defect energy level of the oxygen vacancy y3 is deep, the large quantity of oxygen vacancies y3 may capture and accumulate electrons (as shown in b1 in FIG. 5), introduce a built-in electric field, generate nailing effect on an electric domain in a specific polarization direction, and even may cause breakdown of the dielectric layer 30, resulting in low reliability of the dielectric layer 30. It should be understood that, in b1 in FIG. 5, n1 represents an energy level of a metal for manufacturing the first conductive layer, and n2 represents an energy level of a metal for manufacturing the function layer.

**Table 1**

| Doping type | Whether a ferroelectric layer is formed | Thermal budget | Reliability |
|---|---|---|---|
| First doped layer | Yes | High | Low |
| Second doped layer | No | Not related | Not related |
| First doped layer and second doped layer | Yes | Low | High |

As shown in a2 in FIG. 5, when the dielectric layer 30 includes only the hafnium oxide layer and the second doped layer 30c, if Helmholtz free energy of a metal element (as shown by y2 in a2 in FIG. 5) in the second doped layer 30c is not lower than the Helmholtz free energy of the metal hafnium element y0, it indicates that the metal element y2 in the second doped layer 30c needs high energy during movement, a small quantity of defects are generated in the dielectric layer 30, energy levels of the defects are shallow, and electrons (as shown in b2 in FIG. 5) are difficult to capture and accumulate. In addition, the hafnium oxide layer is difficult to exhibit ferroelectricity, and thus the ferroelectric layer 30a is difficult to form.

As shown in a3 in FIG. 5, when the dielectric layer 30 includes the hafnium oxide layer, the first doped layer 30b, and the second doped layer 30c, because the Helmholtz free energy of the metal element y1 in the first doped layer 30b is lower than the Helmholtz free energy of the metal hafnium element y0, a defect is more easily generated in the dielectric layer 30, and a large quantity of oxygen vacancies y3 are generated, so that the hafnium oxide layer can exhibit the ferroelectricity through the oxygen vacancy y3, to form the ferroelectric layer 30a. In addition, because the Helmholtz free energy of the metal element y2 in the second doped layer 30c is not lower than the Helmholtz free energy of the metal element y0 in the ferroelectric layer 30a, a small quantity of defects are generated in the dielectric layer 30 and energy levels of the defects are shallow. These defects with shallow energy levels can guide the captured and accumulated electrons (as shown in b3 in FIG. 5), to avoid electron aggregation and accumulation in the dielectric layer 30, so as to avoid breakdown of the dielectric layer 30 due to electron aggregation and accumulation. Therefore, through introduction of the first doped layer 30b and the second doped layer 30c that have different functions, the ferroelectric layer 30a can be obtained, and reliability of the dielectric layer 30 and even reliability of the storage unit can be further improved.

It should be understood that, in addition to the hafnium oxide material, the manufacturing material of the ferroelectric layer 30a may include another material having a characteristic similar to that of the hafnium oxide material. This is not limited herein. The characteristic of the hafnium oxide material means that the pure hafnium oxide material is difficult to exhibit the ferroelectricity. When the oxygen vacancy is introduced or the first doped layer 30b is introduced, hafnium oxide can exhibit the ferroelectricity.

For example, in addition to the requirement of the Helmholtz free energy, the metal element in the first doped layer 30b may meet the following requirement: A difference between an atomic radius of the metal element in the first doped layer 30b and an atomic radius of the metal element in the ferroelectric layer 30a is not less than a threshold, that is, the difference between the atomic radius of the metal element in the first doped layer 30b and the atomic radius of the metal element in the ferroelectric layer 30a is large. In this way, when the metal in the first doped layer 30b is introduced, a caused lattice distortion of a material in the ferroelectric layer 30a is large, and crystallization of the material in the ferroelectric layer 30a is greatly affected, thereby facilitating formation of the ferroelectric layer 30a. Alternatively, a valence state of the metal element in the first doped layer 30b is lower than a valence state of the metal element in the ferroelectric layer 30a. In this way, stability of bonding between the metal in the first doped layer 30b and oxygen is low, and a large quantity of oxygen vacancies are easily introduced. This also has large impact on crystallization of the material in the ferroelectric layer 30a, thereby facilitating formation of the ferroelectric layer 30a. Alternatively, a difference between an atomic radius of the metal element in the first doped layer 30b and an atomic radius of the metal element in the ferroelectric layer 30a is not less than a threshold, and a valence state of the metal element in the first doped layer 30b is lower than a valence state of the metal element in the ferroelectric layer 30a. In this way, formation of the ferroelectric layer 30a can be facilitated from two perspectives of causing a lattice distortion of a material in the ferroelectric layer 30a and introducing an oxygen vacancy. In this case, the metal element in the first doped layer 30b may include, but is not limited to, at least one of lanthanum, cerium, molybdenum, zirconium, silicon, gadolinium, yttrium, and the like. It should be understood that a metal may have a plurality of valence states, but provided that one of the valence states is lower than the valence state of the metal element in the ferroelectric layer 30a, it may be considered that the metal meets the requirement that the valence state is lower than the valence state of the metal element in the ferroelectric layer 30a.

In addition, an example in which the manufacturing material of the ferroelectric layer 30a includes the hafnium oxide material is used. The hafnium oxide material has a plurality of phase structures, where a T phase, an O phase, and an M phase are the most common. A ferroelectric phase is a type of the O phase. In a heat treatment process, hafnium oxide may form the T phase as a temperature rises, and then is converted into the O phase or the M phase in a cooling process. In this case, the first doped layer 30b may include one metal element. The metal element may stabilize hafnium oxide in the O phase, so that hafnium oxide exhibits the ferroelectricity, to form the ferroelectric layer 30a. Alternatively, as shown in the following Table 2, the first doped layer 30b may include a plurality of metal elements. Some metal elements (which are denoted as a type-A metal element) in these metal elements are used to stabilize hafnium oxide in the O phase, so that hafnium oxide exhibits the ferroelectricity, to form the ferroelectric layer 30a. Therefore, a function of the type-A metal element includes facilitating formation of the ferroelectric layer 30a. Some other metal elements (which are denoted as a type-B metal element) in these metal elements are used to cause hafnium oxide to form the T phase, so that hafnium oxide is a mixture of the O phase and the T phase. In this way, a heat treatment temperature can be reduced, and a thermal budget needed for crystallization can be reduced. Therefore, a function of the type-B metal element includes reducing the heat treatment temperature needed in a ferroelectric layer 30a forming process, so that when the ferroelectric layer 30a is obtained and reliability of the dielectric layer 30 is improved, the thermal budget for forming the ferroelectric layer 30a can be further reduced. The type-A metal element may include, but is not limited to, at least one of lanthanum, cerium, molybdenum, and the like, and the type-B metal element may include, but is not limited to, at least one of zirconium, silicon, gadolinium, yttrium, and the like.

**Table 2**

| Element type | Crystal phase | Thermal budget |
|---|---|---|
| Type-A metal element | Mainly O phase | High |
| Type-B metal element | Mixture of the O phase and the T phase | Low |

Similarly, in addition to the requirement of the Helmholtz free energy, the metal element in the second doped layer 30c may meet the following requirement: A difference between an atomic radius of the metal element in the second doped layer 30c and the atomic radius of the metal element in the ferroelectric layer 30a is less than the threshold, that is, the atomic radius of the metal element in the second doped layer 30c is close to the atomic radius of the metal element in the ferroelectric layer 30a. In this way, when the metal in the second doped layer 30c is introduced, the caused lattice distortion of the material in the ferroelectric layer 30a is small, impact on crystallization of the material in the ferroelectric layer 30a is small, and a generated defect energy level is shallow, so that accumulated electrons can be guided, thereby avoiding electron aggregation. Alternatively, a valence state of the metal element in the second doped layer 30c is not lower than the valence state of the metal element in the ferroelectric layer 30a. In this way, bonding between the metal in the second doped layer 30c and oxygen is relatively stable, it is difficult to introduce an oxygen vacancy or a small quantity of oxygen vacancies are introduced, and a generated defect energy level is shallow, so that accumulated electrons can be guided, thereby avoiding electron aggregation. Alternatively, a difference between an atomic radius of the metal element in the second doped layer 30c and the atomic radius of the metal element in the ferroelectric layer 30a is less than the threshold, and a valence state of the metal element in the second doped layer 30c is not lower than the valence state of the metal element in the ferroelectric layer 30a. In this case, the metal element in the second doped layer 30c may include, but is not limited to, at least one of titanium and niobium. It should be understood that a metal may have a plurality of valence states, but provided that one of the valence states is not lower than the valence state of the metal element in the ferroelectric layer 30a, it may be considered that the metal meets the requirement that the valence state is not lower than the valence state of the metal element in the ferroelectric layer 30a.

The threshold may be set based on factors such as requirements for a storage window and reliability of the storage unit. For example, the threshold may be set to 10 pm. This is not limited herein. It should be understood that, a ferroelectric polarization state is strong and remains unchanged within the storage window of the storage unit, and the polarization state is weak or flips outside the storage window. Therefore, the storage window of the storage unit has a high storage capacity, so that information can be stably recorded, and data storage can be implemented.

For example, the metal element in the first doped layer is lanthanum and zirconium, and the metal element in the second doped layer is titanium. Refer to the following Table 3. La:HfO₂ represents hafnium oxide doped with lanthanum, Zr:HfO₂ represents hafnium oxide doped with zirconium, Ti:HfO₂ represents hafnium oxide doped with titanium, La:Ti:HfO₂ represents hafnium oxide doped with lanthanum and titanium, and La:Zr:Ti:HfO₂ represents hafnium oxide doped with lanthanum, zirconium, and titanium in the table.

**Table 3**

| Types of doped elements | Crystal phase | Scalability | Thermal budget | Reliability |
|---|---|---|---|---|
| La:HfO₂ | Mainly O phase | Good | High | Low |
| Zr:HfO₂ | Mixture of the O phase and the T phase | Poor | Low | Medium |
| Ti:HfO₂ | Difficult to form the O phase or the T phase | Not related | Not related | Not related |
| La:Ti:HfO₂ | Mainly O phase | Good | High | High |
| La:Zr:Ti:HfO₂ | Mainly O phase | Good | Low | High |

It can be learned from the result shown in Table 3 that, for hafnium oxide doped with lanthanum, although a proportion of the O phase may be increased, to make the O phase dominant, and cause hafnium oxide to exhibit ferroelectricity, this needs a high heat treatment temperature, resulting in a high thermal budget and poor reliability. A crystal phase of hafnium oxide doped with zirconium is the mixture of the O phase and the T phase, which can reduce the proportion of the O phase, so that hafnium oxide can exhibit the ferroelectricity and the thermal budget can be further reduced. For hafnium oxide doped with titanium, due to the difficulty in forming the O phase or the T phase, hafnium oxide is difficult to exhibit the ferroelectricity. For hafnium oxide doped with lanthanum and titanium, hafnium oxide can exhibit the ferroelectricity and the reliability can be further improved due to effects of lanthanum and titanium, but the thermal budget is high due to the effect of lanthanum. For hafnium oxide doped with lanthanum, zirconium, and titanium, hafnium oxide can exhibit the ferroelectricity, and the reliability can be further improved due to effects of lanthanum, zirconium, and titanium, and the thermal budget can be further reduced due to the effect of zirconium. In addition, for hafnium oxide doped with zirconium, because the O phase and the T phase are mixed, to easily form polycrystal, and when a device area is scaled down, it is difficult to ensure consistency between crystal phases of different storage units, resulting in poor scalability of a device. However, for hafnium oxide doped with lanthanum, zirconium, and titanium, the effects of lanthanum and titanium can compensate for a problem of poor scalability caused by a case in which only zirconium is doped, thereby improving scalability of the device. Therefore, in an actual situation, a doped element may be selected based on a requirement for the thermal budget, a requirement for the reliability, a requirement for the scalability, and the like.

The storage unit may include a storage capacitor. When the dielectric layer 30 is used in the storage capacitor, the function layer 20 may be used as a second conductive layer in the storage capacitor, and the first conductive layer 10 and the second conductive layer are separately arranged on two sides of the dielectric layer 30, to form the storage capacitor. A storage window of the dielectric layer 30 in the storage capacitor affects storage performance of the storage capacitor, and further affects performance of the storage unit. Through introduction of the first doped layer 30b, the ferroelectric layer 30a may be obtained, to obtain a sufficient storage window, so as to implement data storage. In addition, through introduction of the second doped layer 30c, reliability of the dielectric layer 30 can be improved, so that reliability of the dielectric layer 30 is improved without losing the storage window.

In addition, in the storage capacitor, when the storage capacitor is arranged on a substrate (not shown in FIG. 3 and FIG. 4), the first conductive layer 10, the dielectric layer 30, and the function layer 20 may be stacked in a direction (namely, a z direction shown in FIG. 3 and FIG. 4) perpendicular to a surface of the substrate, and the dielectric layer 30 is arranged between the first conductive layer 10 and the function layer 20. In this case, the storage capacitor may be considered as a storage capacitor having a two-dimensional structure.

For example, a manufacturing material of the first conductive layer 10 may include any material having a conductive function, for example, but not limited to, a metal, a metal oxide, and a conductive organic material. Specifically, the material may be selected based on an actual requirement. This is not limited herein. When the function layer 20 is used as the second conductive layer, a manufacturing material of the function layer 20 may be the same as or different from the manufacturing material of the first conductive layer 10, and may be specifically selected based on an actual requirement. This is not limited herein.

The first conductive layer 10 and the function layer 20 used as the second conductive layer each may be referred to as a conductive film layer. For example, as shown in FIG. 4, a film layer having an auxiliary function, for example, but not limited to, an adhesion layer 40 or an interface passivation layer (not shown in FIG. 4), may be arranged between the conductive film layer and the dielectric layer 30. When the adhesion layer 40 is arranged, adhesion between the dielectric layer 30 and the conductive film layer may be increased through the adhesion layer 40, to avoid detachment between the conductive film layer and the dielectric layer 30 during use of the storage unit, so as to improve reliability of the storage unit. A manufacturing material of the adhesion layer 40 may be selected based on a manufacturing material of the conductive film layer. Any material that can serve an adhesion function may be used to manufacture the adhesion layer 40. When the interface passivation layer is arranged, element diffusion between the dielectric layer and the conductive film layer can be suppressed through the interface passivation layer, to avoid function degradation of the conductive film layer and the dielectric layer, so as to improve ferroelectricity of the dielectric layer and improve the reliability of the storage unit. A manufacturing material of the interface passivation layer may also be selected based on the manufacturing material of the conductive film layer. Any material that can serve an interface passivation function may be used to manufacture the interface passivation layer.

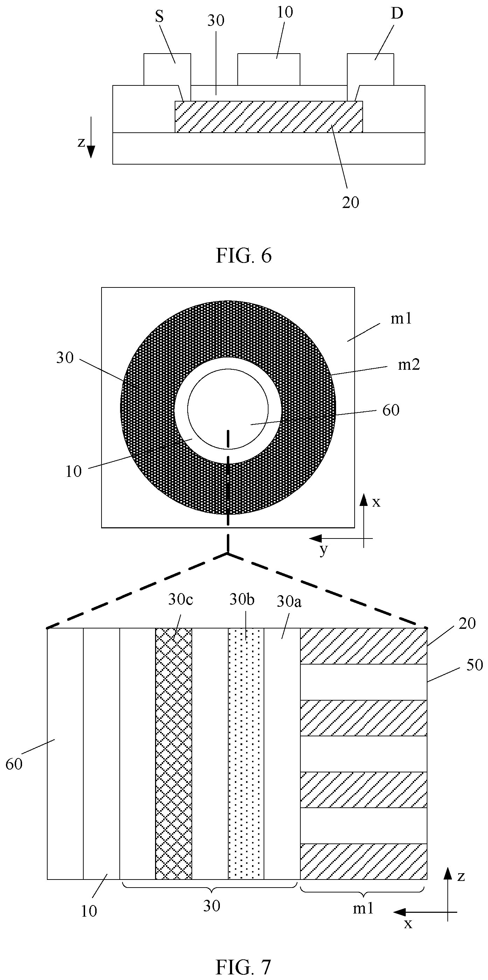

In a second embodiment, FIG. 6 is an example diagram of a structure of a storage unit according to an embodiment of this application. Refer to FIG. 6. A structure of the storage unit in the second embodiment is basically similar to that of the storage unit in the foregoing first embodiment, and a difference lies in that an application scenario of the dielectric layer 30 is different. For example, when the storage unit includes a transistor, the dielectric layer 30 may be used in the transistor. In this case, the function layer 20 may be used as a channel of the transistor, the first conductive layer 10 may be used as a gate of the transistor, and the dielectric layer 30 is used as a gate insulation layer to isolate the gate from the channel in the transistor, to avoid a short circuit between the channel and the gate. Therefore, when the dielectric layer 30 has good reliability, reliability and performance of the transistor are also improved. In addition, when being used as the channel of the transistor, the function layer 20 may be made of a semiconductor material, and selection may be specifically performed based on an actual requirement. This is not limited herein. In FIG. 6, S represents a source of the transistor, and D represents a drain of the transistor.

It should be understood that, for a similarity between the structure of the storage unit in the second embodiment and the structure of the storage unit in the foregoing first embodiment, refer to the foregoing first embodiment. Details are not described again.

In a third embodiment, FIG. 7 is an example diagram of a structure of a storage unit according to an embodiment of this application. A structure of the storage unit in the third embodiment is basically similar to that of the storage unit in the foregoing first embodiment, and a difference lies in that a storage capacitor is of a three-dimensional structure. Refer to FIG. 7. The function layer 20 and an insulation layer 50 may be alternately stacked in a direction (namely, a z direction) perpendicular to a surface of a substrate (not shown in FIG. 7) to form a stacked structure m1, and then a through hole m2 is excavated in the stacked structure m1. The through hole m2 runs through the stacked structure m1 in the stacking direction (namely, the z direction), and then the through hole m2 is sequentially filled with the dielectric layer 30 and the first conductive layer 10. The dielectric layer 30 is arranged between the stacked structure m1 and the first conductive layer 10. In this case, a stacking direction (namely, an x direction) of the ferroelectric layer 30a, the first doped layer 30b, and the second doped layer 30c is perpendicular to an extension direction (namely, the z direction) of the through hole m2. In this case, the formed storage capacitor may be considered as a storage capacitor having a three-dimensional structure. Therefore, the storage unit may be of a two-dimensional structure and a three-dimensional structure, to extend an application range of the storage unit. In addition, the through hole m2 may be filled with the dielectric layer 30, the first conductive layer 10, and a filling layer 60, and the filling layer 60 is arranged on a side (as shown in a left side in a sectional view of FIG. 7) of the first conductive layer 10 facing away from the dielectric layer 30. The filling layer 60 may be made of an insulation material. In this way, the manufacturing material of the first conductive layer 10 can be reduced, and when costs of the manufacturing material of the first conductive layer 10 are high and costs of the manufacturing material of the filling layer 60 are low, this can effectively reduce manufacturing costs of the storage unit. Alternatively, the through hole m2 may be filled with the dielectric layer 30 and the first conductive layer 10, that is, a space that is not occupied by the dielectric layer 30 and that is in the through hole m2 is filled with the first conductive layer 10. In this way, a manufacturing step and a manufacturing process of the storage unit can be simplified, and manufacturing efficiency can be improved.

It should be understood that, for a similarity between the structure of the storage unit in the third embodiment and the structure of the storage unit in the foregoing first embodiment, refer to the foregoing first embodiment. Details are not described again.

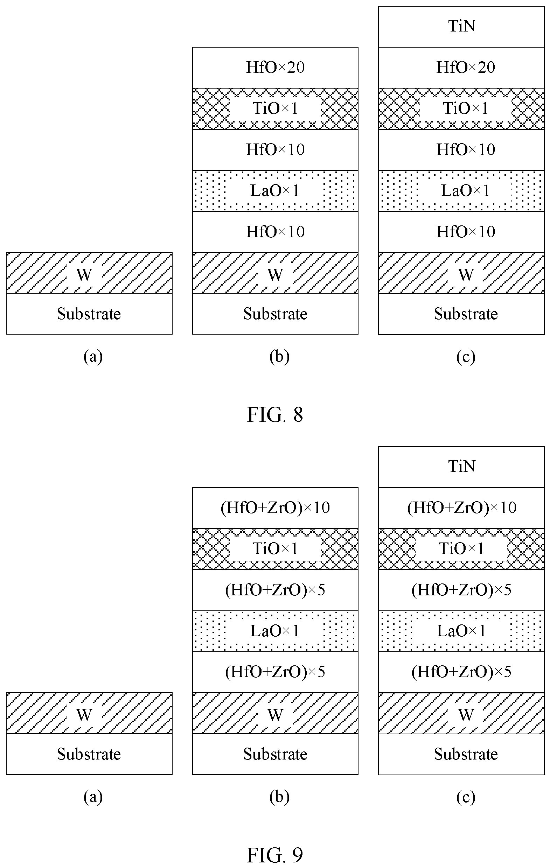

In a fourth embodiment, FIG. 8 is an example diagram of a storage unit manufacturing method according to an embodiment of this application. Refer to FIG. 8. An example in which a dielectric layer is used in a storage capacitor, an initial film layer is manufactured by using hafnium oxide, a first doped layer is manufactured by using lanthanum oxide, and a second doped layer is manufactured by using titanium oxide is used. A specific manufacturing process of the storage unit may include the following steps.

S1: As shown in (a) in FIG. 8, manufacture a W film layer on a substrate by using a physical vapor deposition method as a function layer, where the function layer may be considered as a second conductive layer.

S2: As shown in (b) in FIG. 8, stack and form ten layers of hafnium oxide, one layer of lanthanum oxide, ten layers of hafnium oxide, one layer of titanium oxide, and 20 layers of hafnium oxide on the function layer by using an atomic layer deposition method, where the ten layers of hafnium oxide or the 20 layers of hafnium oxide are used as the initial film layer, the one layer of lanthanum oxide is used as the first doped layer, the one layer of titanium oxide is used as the second doped layer, and the initial film layer, the first doped layer, and the second doped layer form an initial dielectric layer.

For example, a deposition rate of a hafnium oxide layer may be, but is not limited to, 1.07 Å/cycle, a deposition rate of a lanthanum oxide layer may be, but is not limited to, 0.46 Å/cycle, and a deposition rate of a titanium oxide layer may be, but is not limited to, 0.50 Å/cycle. In addition, a total thickness of the initial film layer, the first doped layer, and the second doped layer that are stacked and that are obtained in S2 may be, but is not limited to, 80Å.

In addition, the initial film layer that is in the initial dielectric layer and that is located at a topmost layer is manufactured slightly thicker, so that a doped element in the first doped layer or the second doped layer can be mainly reserved inside the initial dielectric layer, and a case in which the doping element is close to a surface of the initial dielectric layer is avoided, thereby avoiding introduction of an additional interface effect and improving reliability of the storage unit.

It should be understood that a plurality of layers of hafnium oxide included in the initial film layer are continuously manufactured, so that it can be ensured that the initial film layer has a specific thickness, and a quantity of layers of hafnium oxide included in the initial film layer is not limited to 10 or 20. The quantity is merely an example for description herein, and may be specifically set based on an actual situation. This is not limited herein.

S3: Perform heating processing on the initial dielectric layer, perform cooling processing when a temperature rises to a first preset temperature, and end a heat treatment process when the temperature falls to a second preset temperature, so that the initial film layer is converted into a ferroelectric layer, to obtain a dielectric layer.

S4: As shown in (c) in FIG. 8, manufacture a TiN film layer on the dielectric layer by using the physical vapor deposition method as a first conductive layer.

In this way, introduction of the first doped layer can help the dielectric layer exhibit ferroelectric performance, and captured and accumulated electrons can be guided through introduction of the second doped layer, to avoid electron aggregation and accumulation in the dielectric layer, so as to avoid breakdown of the dielectric layer due to electron aggregation and accumulation. Therefore, when a ferroelectric storage unit is obtained, reliability of the dielectric layer and even reliability of the storage unit are improved.

It should be understood that, in this embodiment, the storage unit manufacturing method is described merely by using FIG. 8 as an example. A stacking sequence of the initial film layer, the first doped layer, and the second doped layer is not limited to that shown in FIG. 8, or may be another stacking sequence, which is not shown in this embodiment. Any stacking sequence in which the ferroelectric layer is arranged between different first doped layers, the ferroelectric layer is arranged between different second doped layers, and the ferroelectric layer is arranged between the first doped layer and the second doped layer is applicable to embodiments of this application.

In a fifth embodiment, FIG. 9 is an example diagram of a storage unit manufacturing method according to an embodiment of this application. Refer to FIG. 9. The manufacturing method in the fifth embodiment is basically similar to the manufacturing method in the foregoing fourth embodiment, and a difference lies in that different doped elements are introduced. For example, in the fifth embodiment, an example in which an initial film layer is manufactured by using hafnium oxide, a first doped layer is manufactured by using lanthanum oxide and zirconium oxide, and a second doped layer is manufactured by using titanium oxide is used. In this case, S2 in the foregoing fourth embodiment may be adjusted as follows. Refer to (b) in FIG. 9. Five hafnium oxide and zirconium oxide combined film layers, one layer of lanthanum oxide, five combined film layers, one layer of titanium oxide, and ten combined film layers are stacked and formed on the function layer by using the atomic layer deposition method. Hafnium oxide in the combined film layer is used as the initial film layer, lanthanum oxide and zirconium oxide in the combined film layer are used as the first doped layer, titanium oxide is used as the second doped layer, and the initial film layer, the first doped layer, and the second doped layer form an initial dielectric layer. In this case, it may be understood that zirconium oxide is doped into the initial film layer, and both the lanthanum oxide layer and the titanium oxide layer are doped outside the initial film layer. Alternatively, five layers of hafnium oxide, one layer of zirconium oxide, five layers of hafnium oxide, one layer of lanthanum oxide, five layers of hafnium oxide, one layer of titanium oxide, and ten layers of hafnium oxide are stacked and formed on the function layer by using the atomic layer deposition method. Hafnium oxide is used as the initial film layer, lanthanum oxide and zirconium oxide are used as the first doped layer, titanium oxide is used as the second doped layer, and the initial film layer, the first doped layer, and the second doped layer form an initial dielectric layer. In this case, it may be understood that zirconium oxide, the lanthanum oxide layer, and the titanium oxide layer are doped outside the initial film layer. A deposition rate of the zirconium oxide layer may be, but is not limited to, 0.93 Å/cycle. For deposition rates of hafnium oxide, the lanthanum oxide layer, and the titanium oxide layer, refer to the foregoing fourth embodiment. Details are not described again.

Refer to (a) in FIG. 9. It should be understood that, S1 in the fifth embodiment is the same as S1 in the foregoing fourth embodiment; and S3 in the fifth embodiment is the same as S3 in the foregoing fourth embodiment. Refer to (c) in FIG. 9. S4 in the fifth embodiment is the same as S4 in the foregoing fourth embodiment. Therefore, for a similarity between the manufacturing method in the fifth embodiment and the manufacturing method in the foregoing fourth embodiment, refer to the foregoing fourth embodiment. Details are not described again.

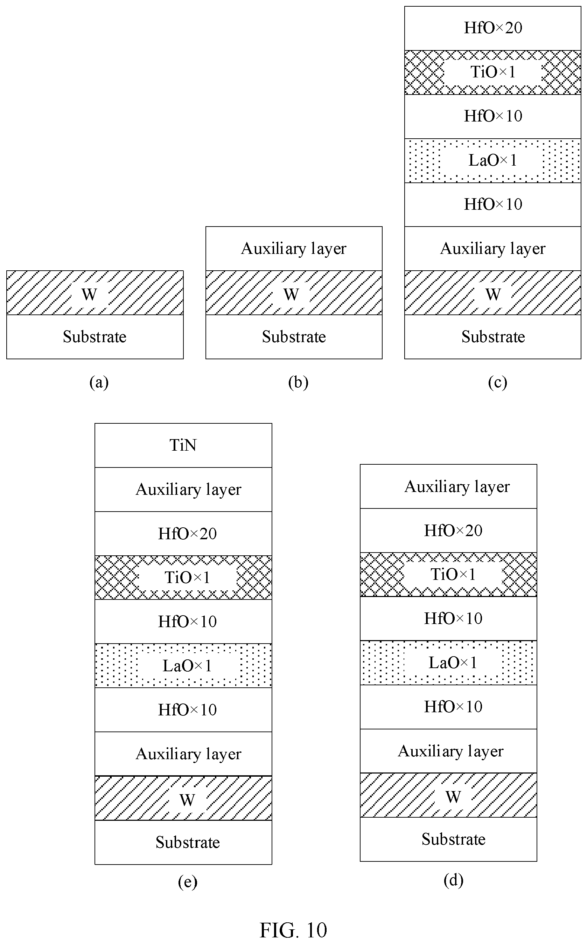

In a sixth embodiment, FIG. 10 is an example diagram of a storage unit manufacturing method according to an embodiment of this application. Refer to FIG. 10. The manufacturing method in the sixth embodiment is basically similar to the manufacturing method in the foregoing fourth embodiment, and a difference includes the following steps.
(1) Step k1 is added between S1 and S2 in the foregoing fourth embodiment. Refer to (b) in FIG. 10. Step k1 may specifically include: forming an auxiliary layer having an auxiliary function on the function layer, where the auxiliary function of the film layer may be, but is not limited to, an adhesion function, an interface passivation function, and the like.
(2) Step k2 is added between S3 and S4 in the foregoing fourth embodiment. Refer to (d) in FIG. 10. Step k2 may specifically include: forming an auxiliary layer having an auxiliary function on the dielectric layer, where the auxiliary function of the film layer may be, but is not limited to, the adhesion function, the interface passivation function, and the like.

In this way, reliability of the storage unit can be further improved by using the film layer having the auxiliary function.

Refer to (a) in FIG. 10. It should be understood that, S1 in the sixth embodiment is the same as S1 in the foregoing fourth embodiment. Refer to (c) in FIG. 10. S2 in the sixth embodiment is the same as S2 in the foregoing fourth embodiment; and S3 in the sixth embodiment is the same as S3 in the foregoing fourth embodiment. Refer to (e) in FIG. 10. S4 in the sixth embodiment is the same as S4 in the foregoing fourth embodiment. Therefore, for a similarity between the manufacturing method in the sixth embodiment and the manufacturing method in the foregoing fourth embodiment, refer to the foregoing fourth embodiment. Details are not described again.

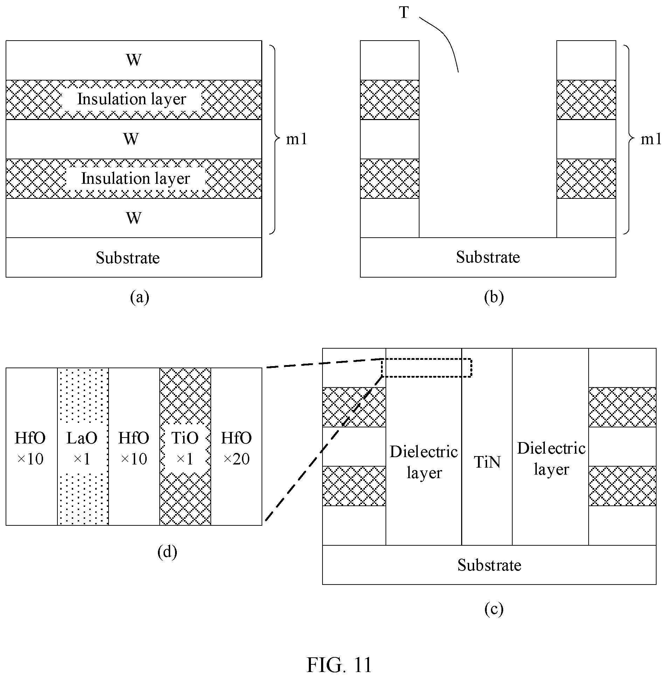

In a seventh embodiment, FIG. 11 is an example diagram of a storage unit manufacturing method according to an embodiment of this application. Refer to FIG. 11. The manufacturing method in the seventh embodiment is basically similar to the manufacturing method in the foregoing fourth embodiment, and a difference includes the following steps.
(1) S1 is adjusted as follows: As shown in (a) in FIG. 11, a metal W film layer and an insulation layer are alternately deposited on a substrate by using a chemical vapor deposition method, to obtain a stacked structure m1, where the metal W film layer is used as a function layer, and the stacked structure m1 includes a plurality of function layers and a plurality of insulation layers.
(2) Step k3 is added between S1 and S2. Step k3 may include: as shown in (b) in FIG. 11, opening a hole on the stacked structure m1 through photolithography and high-aspect-ratio dry etching, to obtain a columnar through hole T with a diameter of about 50 nm, where the through hole T runs through the stacked structure m1 in a stacking direction.
(3) Manufacture all film layers formed in S2 to S4 in the through hole T, as shown in (c) and (d) in FIG. 11.
(4) If the TiN film layer formed in S4 does not fill a remaining space in the through hole T, a filling layer needs to be further formed after the TiN film layer is formed, and the unoccupied space of the through hole T is filled with the filling layer, which is not shown in the figure. A process of manufacturing the filling layer includes: depositing an insulation layer on the TiN film layer by using an insulation material by using a chemical vapor deposition method, to fill the through hole T, where the insulation material may be the same as or different from a manufacturing material of the insulation layer.

In this way, the obtained storage capacitor is of a three-dimensional structure, to extend an application range of the ferroelectric storage unit.

It should be understood that, in the seventh embodiment, a process of forming each film layer in the initial dielectric layer is the same as S2 in the foregoing fourth embodiment, a process of processing the initial dielectric layer to obtain the dielectric layer in the seventh embodiment is the same as S3 in the foregoing fourth embodiment, and a process of manufacturing the TiN film layer in the seventh embodiment is the same as S4 in the foregoing fourth embodiment. Therefore, for a similarity between the manufacturing method in the seventh embodiment and the manufacturing method in the foregoing fourth embodiment, refer to the foregoing fourth embodiment. Details are not described again.

Clearly, a person skilled in the art can make various modifications and variations to embodiments of this application without departing from the spirit and scope of embodiments of this application. In this case, this application is intended to cover these modifications and variations of embodiments of this application provided that they fall within the scope of protection defined by the following claims and their equivalent technologies.

## Claims

1. A storage unit, comprising a first conductive layer, a function layer, and a dielectric layer arranged between the first conductive layer and the function layer, wherein the dielectric layer comprises a ferroelectric layer, a first doped layer, and a second doped layer that are stacked; and Helmholtz free energy of a metal element in the first doped layer is lower than Helmholtz free energy of a metal element in the ferroelectric layer, and Helmholtz free energy of a metal element in the second doped layer is not lower than the Helmholtz free energy of the metal element in the ferroelectric layer.

2. The storage unit according to claim 1, wherein a difference between an atomic radius of the metal element in the second doped layer and an atomic radius of the metal element in the ferroelectric layer is less than a threshold, and/or a valence state of the metal element in the second doped layer is not lower than a valence state of the metal element in the ferroelectric layer.

3. The storage unit according to claim 1 or 2, wherein a plurality of second doped layers are arranged, and a ferroelectric layer is arranged between two adjacent second doped layers.

4. The storage unit according to any one of claims 1 to 3, wherein the second doped layer comprises at least one of titanium and niobium.

5. The storage unit according to any one of claims 1 to 4, wherein a difference between an atomic radius of the metal element in the first doped layer and the atomic radius of the metal element in the ferroelectric layer is not less than the threshold, and/or a valence state of the metal element in the first doped layer is lower than the valence state of the metal element in the ferroelectric layer.

6. The storage unit according to any one of claims 1 to 5, wherein a plurality of first doped layers are arranged, and a ferroelectric layer is arranged between two adjacent first doped layers.

7. The storage unit according to any one of claims 1 to 6, wherein the first doped layer comprises at least one of lanthanum, cerium, molybdenum, zirconium, silicon, gadolinium, and yttrium.

8. The storage unit according to any one of claims 1 to 7, wherein the ferroelectric layer is arranged between the first doped layer and the second doped layer.

9. The storage unit according to any one of claims 1 to 8, wherein the storage unit comprises a storage capacitor, and the function layer is a second conductive layer.

10. The storage unit according to any one of claims 1 to 8, wherein the storage unit comprises a transistor, the function layer is a channel in the transistor, and the first conductive layer is a gate in the transistor.

11. The storage unit according to any one of claims 1 to 10, wherein a manufacturing material of the ferroelectric layer comprises a hafnium oxide material.

12. A method for manufacturing the storage unit according to any one of claims 1 to 11, comprising:
forming a function layer;
stacking and forming a ferroelectric layer, a first doped layer, and a second doped layer on the function layer, wherein the ferroelectric layer, the first doped layer, and the second doped layer form a dielectric layer, Helmholtz free energy of a metal element in the first doped layer is lower than Helmholtz free energy of a metal element in the ferroelectric layer, and Helmholtz free energy of a metal element in the second doped layer is not lower than the Helmholtz free energy of the metal element in the ferroelectric layer; and
forming a first conductive layer on the dielectric layer.

13. The method according to claim 12, wherein stacking and forming the ferroelectric layer, the first doped layer, and the second doped layer on the function layer comprises:
stacking and forming an initial film layer, the first doped layer, and the second doped layer on the function layer;
and
performing heat treatment on the initial film layer, the first doped layer, and the second doped layer, so that the initial film layer is converted into the ferroelectric layer.

14. A memory, comprising a storage array and a controller coupled to the storage array, wherein the storage array comprises a plurality of storage units according to any one of claims 1 to 11, and the plurality of storage units are deployed in an array manner;
the storage array is configured to store data; and
the controller is configured to write data into the storage array, or read data from the storage array.

15. An electronic device, comprising a circuit board and the memory according to claim 14, wherein the memory is arranged on the circuit board.
